# EUROPÄISCHE PATENTSCHRIFT

(11) **EP 3 048 808 B1**
(45) Veröffentlichungstag und Bekanntmachung des Hinweises auf die Patenterteilung: **08.04.2020**
(21) Anmeldenummer: 16151895.6
(22) Anmeldetag: 19.01.2016
(51) Int. Cl.: H04R 3/00, G11B 20/10, H03G 3/30, H03G 7/00, H04R 25/00

(54) **DIGITALES DRAHTLOS-AUDIOÜBERTRAGUNGSSYSTEM MIT OPTIMIERTER DYNAMIK**
DIGITAL WIRELESS AUDIO TRANSMISSION SYSTEM WITH OPTIMIZED DYNAMICS
SYSTEME DE TRANSMISSION AUDIONUMERIQUE SANS FIL AYANT UNE DYNAMIQUE OPTIMISEE

(30) Priorität: 21.01.2015 DE 102015200961
(43) Veröffentlichungstag der Anmeldung: 27.07.2016
(73) Patentinhaber: Sennheiser electronic GmbH & Co. KG, 30900 Wedemark (DE)
(72) Erfinder: Musialik, Christoph, 79790 Küssaberg (DE); Frey, Tom-Fabian, 38104 Braunschweig (DE); Hermerding, Andreas, 79677 Schönau im Schwarzwald (DE); Musialik, Thomas, 79761 Waldshut-Tiengen (DE); Rieck, Sebastian, 79805 Eggingen (DE); Thiele, Markus, 30459 Hannover (DE); Wachtendorf, Sven, 30900 Wedemark (DE)
(74) Vertreter: Eisenführ Speiser

(56) Entgegenhaltungen:
- "TLV320ADC3101 Low-Power Stereo ADC With Embedded miniDSP for Wireless Handsets and Portable Audio", , 1. Oktober 2008 (2008-10-01), Seiten 1--92, XP055273076, Internet Gefunden im Internet: URL:http://www.ti.com/lit/ds/slas553b/slas 553b.pdf [gefunden am 2016-05-17]
- Juan Pablo Alegre Pérez ET AL: "AGC Fundamentals" In: "Automatic Gain Control", 1. Januar 2011 (2011-01-01), Springer New York, New York, NY, XP055273078, ISBN: 978-1-4614-0167-4 Seiten 13-28, DOI: 10.1007/978-1-4614-0167-4_2, * Seiten 13,14; Abbildung 2.1 *
- Semiconductor ET AL: "AND8227/D Compandor Application Automatic Gain Control INTRODUCTION", - Rev. 0 1 Publication Order Number, 1 January 2005 (2005-01-01), XP055407837, Retrieved from the Internet: URL:https://www.onsemi.com/pub/Collateral/ AND8227-D.PDF [retrieved on 2017-09-19]
- Texas Instruments: "AN-1451 LM4935 Automatic Gain Control (AGC) Guide", , 30 April 2006 (2006-04-30), XP055367141, Retrieved from the Internet: URL:http://www.ti.com/lit/an/snaa028a/snaa 028a.pdf [retrieved on 2017-04-25]

## Beschreibung

Die vorliegende Erfindung betrifft ein digitales Drahtlos-Audioübertragungssystem, insbesondere ein digitales Drahtlos-Mikrofonsystem oder ein digitales Taschensendersystem.

Ferner betrifft die Erfindung ein Signalerfassungs- bzw. -bearbeitungssystem, das am Eingang einen Digital/Analog-Wandler aufweist.

Ein drahtloses Audioübertragungssystem, z. B. in Form eines drahtlosen Mikrofonsystems, besteht typischerweise aus mindestens einem drahtlosen Mikrofon, welches die erfassten Audiosignale drahtlos überträgt. Unter diesem Begriff ist nachstehend jedoch auch ein Taschensender gemeint, ohne dass darauf an jeder Textstelle explizit hingewiesen wird. Ein Taschensender ist ein Gerät, an dessen Eingang unterschiedliche Signalquellen angeschlossen werden können, beispielsweise Instrumente, die den Klang elektronisch erzeugen (Synthesizer), aber ebenso Tonwiedergabegeräte (CD-Spieler) und natürlich auch Mikrofone. Die drahtlos übertragenen Audiosignale werden von einem Empfänger empfangen und können dann einer nachfolgenden Audioverarbeitung unterzogen werden. Die drahtlose Audioübertragung erfolgt typischerweise in einem HF-Bereich (Hochfrequenzbereich). Insbesondere bei der drahtlosen Audioübertragung sollen Artefakte hierbei vermieden werden, die aufgrund einer Übersteuerung oder Untersteuerung typischerweise in derartigen Systemen entstehen können. Dies kann durch eine optimal eingestellte, an die Signalstärke angepasste Verstärkung erreicht werden. Dies erfolgt typischerweise durch eine manuelle Einstellung im Mikrofon oder Sender. Insbesondere bei Audiosignalen mit einer großen Dynamik, d. h. mit sich stark veränderbaren Pegeln, ist es schwierig, die entsprechende bzw. optimale Einstellung der Verstärkung zu finden. Oftmals muss die Verstärkung insbesondere an sehr lauten oder sehr leisen Stellen des Audiosignals manuell entsprechend nachjustiert werden und das lässt sich während eines laufenden Konzerts oder Auftritts praktisch nur sehr schwer realisieren, da der Toningenieur hierfür zu dem Künstler/Nutzer auf die Bühne laufen müsste.

Drahtlos-Mikrofonsysteme mit einem analogen Eingangsverstärker und einer internen digitalen Signalverarbeitung weisen oftmals eine nicht optimale Einstellung der Eingangsverstärkung auf, wenn sich die Signalbedingungen an dem Eingang oft stark ändern. Hierbei kann es dazu kommen, dass der dynamische Bereich eines Analog/DigitalWandlers und somit auch einer nachfolgenden Signalverarbeitung nicht optimal genutzt werden. Zur Sicherstellung einer hochqualitativen digitalen Audiosignalverarbeitung ist es wichtig, einen optimalen Aussteuerungspegel an dem Eingang des Analog/DigitalWandlers vorzusehen.

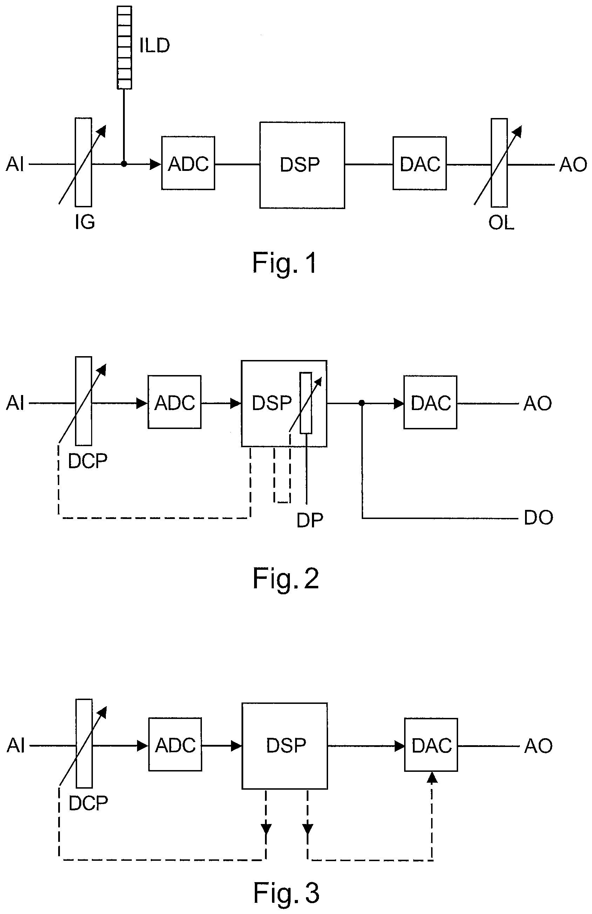

Fig. 1 zeigt eine schematische allgemeine Darstellung eines Systems mit digitaler Signalbearbeitung gemäß dem Stand der Technik. Ein analoger Eingang Al wird einem Verstärker mit einstellbarer Empfindlichkeit zugeführt. Das derart verstärkte und im Pegel eingestellte analoge Signal wird in dem Analog/Digital-Wandler ADC (engl. analog digital converter) digitalisiert. Das digitalisierte Audiosignal wird in einem digitalen Signalprozessor DSP einer Audioverarbeitung unterzogen. Im folgenden Digital/Analog-Wandler DAC (engl. analog digital converter) erfolgt eine Umwandlung von einem digitalen in ein analoges Signal. Das analoge Ausgangssignal des Digital/Analog-Wandlers DAC kann in seiner Verstärkung durch einen einstellbaren Verstärker OL (engl. output level) eingestellt werden, so dass das analoge Ausgangssignal AO mit passendem Pegel an die nächste Stufe des Audiobearbeitungssystems weitergegeben werden kann.

In Abhängigkeit des Eingangspegels wird die Eingangsverstärkung IG vor dem Analog/Digital-Wandler ADC manuell eingestellt, so dass der dynamische Bereich des Analog/Digital-Wandlers ADC, der nachfolgender Signalverarbeitung DSP (engl. digital signal processor) und des nachfolgenden Digital/Analog-Wandlers DAC optimal ausgenutzt werden kann. Falls der dynamische Bereich nicht voll ausgenutzt wird, kann dies dazu führen, dass lediglich einige wenige Bits in dem Analog/Digital-Wandler ADC angesprochen werden. Wenn der Eingangspegel des Audiosignals vor dem Analog/DigitalWandler zu niedrig ist, dann wird typischerweise der Signalpegel am Ausgang der Signalverarbeitung erhöht, was zur Konsequenz haben kann, dass der Signal-Rausch-Abstand verringert wird. Wenn andererseits der Pegel des Eingangsaudiosignals zu hoch ist, kann dies zu einer Übersteuerung bzw. harter Begrenzung der Signale in dem Analog/Digital-Wandler ADC führen. Dies wird typischerweise bei der Wiedergabe eines derartig begrenzten Signals als unangenehm verzerrt empfunden. Die Audiosignalverarbeitung gemäß Fig. 1 kann eine Eingangspegelanzeige ILD (engl. input level display) aufweisen, um dem Benutzer der Anlage den aktuellen Pegel des Eingangssignals anzuzeigen. Unter Berücksichtigung dieses angezeigten Eingangspegels kann dann eine manuelle Einstellung der Eingangsverstärkung IG an dem Eingangsverstärker erfolgen. Dies mag gut funktionieren, wenn die Dynamik des Eingangssignals Al langfristig in einem bestimmten Bereich bleibt. Normalerweise wird dafür während des sog. "Sound-Check" die Verstärkung IG optimal eingestellt, später ist es jedoch aufgrund verschiedener Umständen oftmals nötig, die Verstärkung nachzujustieren, was aber in der Regel nicht mehr möglich ist, da der Toningenieur nicht mehr ständig zu dem Nutzer auf die Bühne laufen kann.

Die Verstärkung bzw. die Empfindlichkeit eines konventionellen drahtlosen Mikrofons kann z. B. durch eine Justierung eines Potentiometers, eine Einstellung von Multipositionsschaltern oder ein Betätigen von Plus- und Minustasten zum Steuern von analogen Schaltern oder Multiplexern erfolgen. Die manuelle Nachjustierung der Mikrofone ist praktisch kaum realisierbar, wenn in einem System eine Vielzahl von drahtlosen Mikrofonen gleichzeitig in Betrieb ist.

Das Datenblatt des TLV320ADC3101 "Low-Power Stereo ADC With Embedded miniDSP for Wireless Handsets and Portable Audio" zeigt das Blockschaltbild eines ICs mit einer "Automatic Gain Control" (AGC). Über einen "Analog Signal Input" werden analoge Audiosignale an ein "PGA" übergeben, dass eine einstellbare Eingangsverstärkung aufweist. Das Ausgangssignal des PGAs wird an einen A/D-Wandler "ADC" übergeben, der in einer getakteten Verarbeitung ein zugehöriges digitales Signal erzeugt. Dieses digitale Signal dient als Eingang der AGC.

In der prioritätsbegründenden deutschen Patentanmeldung hat das Deutsche Patent- und Markenamt die folgenden Dokumente recherchiert: WO 2005/069249 A1; DE 694 14 683 T2 und DE 60 2004 009 432 T2.

Es ist eine Aufgabe der vorliegenden Erfindung, ein Drahtlos-Audioübertragungssystem, insbesondere ein Drahtlos-Mikrofonsystem, vorzusehen, welches eine verbesserte und/oder automatisierte Einstellmöglichkeit der Verstärkung bzw. der Eingangsempfindlichkeit bietet.

Diese Aufgabe wird durch ein Drahtlos-Mikrofonsystem nach Anspruch 1, durch ein Drahtlos-Mikrofon gemäß Anspruch 7 und durch ein Verfahren zum Steuern eines digitalen Drahtlos-Audioübertragungssystems gemäß Anspruch 13 gelöst.

Somit wird ein digitales Drahtlos-Audioübertragungssystem, insbesondere ein Drahtlos- . Mikrofon- oder Drahtlos-Taschensender-System vorgesehen. Das Audioübertragungssystem weist mindestens einen Drahtlos-Sender und einen Drahtlos-Empfänger auf. Der Drahtlos-Sender weist einen analogen Eingang, ein digital einstellbares Eingangspotentiometer zum Einstellen der Eingangsverstärkung, einen Analog/Digital-Wandler zum Wandeln der analogen Signale in digitale Signale, eine digitale Signalverarbeitungseinheit zum Durchführen einer digitalen Signalverarbeitung und ein digitales oder ein digital einstellbares Ausgangspotentiometer zum Einstellen der Ausgangsverstärkung auf. Die digitale Signalverarbeitungseinheit ist dazu ausgestaltet, die Verstärkung des digitalen Eingangspotentiometers und/oder des digitalen Ausgangspotentiometers derart einzustellen, dass der dynamische Bereich des Analog/Digital-Wandlers optimal genutzt wird.

Gemäß einem Aspekt der vorliegenden Erfindung ist die Verstärkung des digitalen oder digital einstellbaren Ausgangspotentiometers entgegengesetzt zu der Verstärkung des Eingangspotentiometers.

Gemäß einem weiteren Aspekt der vorliegenden Erfindung erfolgt die Einstellung der Verstärkung des digitalen Eingangspotentiometers derart, dass die Anzahl der effektiven Bits, welche von dem Analog/Digital-Wandler der nachfolgenden digitalen Signalverarbeitung und dem Digital-/Analogwandler verwendet werden, vergrößert wird. Die Änderung der Verstärkung an dem digitalen Ausgangspotentiometer kompensiert hierbei die Verschiebung der Verstärkung am Eingang, sodass die Verstärkung des Gesamtsystems durch Optimierung der Dynamik nicht beeinflusst wird.

Das erfindungsgemäße Drahtlos-Mikrofonsystem oder Drahtlos-Taschensendersystem (Drahtlos-Audioübertragungssystem) erlaubt eine vereinfachte Handhabung und eine Optimierung der Klangqualität. Erfindungsgemäß wird eine optimale Aussteuerung des Drahtlos-Mikrofonsystems auch bei sich stark änderndem Eingangspegel ermöglicht. Ferner ist eine Verstärker- bzw. manuelle Empfindlichkeitseinstellung nicht mehr notwendig.

Die Erfindung betrifft ebenfalls Signalbearbeitungssysteme, die eine Empfindlichkeitsanpassung am Eingang verlangen, um eine optimale Nutzung des Dynamikbereichs des Systems zu ermöglichen. Als Beispiel aus dem Audiobereich könnte man hier einen Graphik-Equalizer nennen, der in einem Nebenraum montiert ist und durch den Toningenieur deshalb nicht jederzeit einfach erreicht werden kann.

Die Erfindung betrifft einen Gedanken, einen automatischen Mechanismus' mit konstanter Verstärkung für ein digitales System vorzusehen, welches analoge Eingangssignale digital verarbeitet. Gemäß der Erfindung wird eine automatische und optimale Aussteuerung eines digitalen dynamischen Bereiches eines Verarbeitungssystems gewährleistet, welches mit einer Analog/Digital-Wandlung am Eingang und optional einer Digital/Analog-Wandlung am Ausgang arbeitet. Ein digitales Audiosystem kann z. B. eine Analog/DigitalWandlung am Eingang haben aber einen digitalen Ausgang. Eine optimale Aussteuerung bedeutet in diesem Zusammenhang, dass der dynamische Bereich einer typischen Signalverarbeitungskette (Analog/Digital-Wandler, digitale Signalverarbeitung und ggf. Digital/Analog-Wandler) optimal genutzt ist. Üblicherweise wird ein Pegel mit einem Sicherheitsabstand (Aussteuerungsreserve) eingestellt, welcher von einem Anwender ausgewählt werden kann. Somit kann eine hohe Audioqualität im Hinblick auf ein Signal-Rausch-Verhältnis bei einem vorgegebenen dynamischen Bereich des Systems vorgesehen sein.

Weitere Ausgestaltungen der Erfindung sind Gegenstand der Unteransprüche.

Vorteile und Ausführungsbeispiele der Erfindung werden nachstehend unter Bezugnahme auf die Zeichnung näher erläutert.
- Fig. 1: zeigt ein Blockschaltbild einer digitalen Signalverarbeitung gemäß dem Stand der Technik,
- Fig. 2: zeigt ein Blockschaltbild einer Signalverarbeitung gemäß einem ersten Beispiel,
- Fig. 3: zeigt ein Blockschaltbild einer Signalverarbeitung gemäß einem zweiten Beispiel,
- Fig. 4: zeigt ein Blockschaltbild einer Signalverarbeitung gemäß einem dritten Beispiel,
- Fig. 5: zeigt ein Blockschaltbild einer Signalverarbeitung gemäß einem vierten Beispiel,
- Fig. 6: zeigt ein schematisches Blockschaltbild einer Signalverarbeitung, die als Grundlage für ein Ausführungsbeispiel angewendet werden kann, und
- Fig. 7: zeigt eine schematische Darstellung eines Blockschaltbildes eines Drahtlos-Mikrofonsystems gemäß einem fünften Beispiel.

Fig. 2 zeigt ein Blockschaltbild einer Signalverarbeitung gemäß einem ersten Beispiel. Die digitale Signalverarbeitungseinheit gemäß dem ersten Beispiel kann optional ein Drahtlos-Mikrofonsystem darstellen und weist einen analogen Eingang AI, ein digital einstellbares analoges Potentiometer DCP, einen Analog/DigitalWandler ADC, eine digitale Signalverarbeitungseinheit DSP, einen Digital/AnalogWandler DAC sowie einen analogen Ausgang AO und einen digitalen Ausgang DO auf. Das digital einstellbare Potentiometer DCP dient dazu, einen optimalen Durchschnittspegel (unter Berücksichtigung der benötigten Aussteuerungsreserve) des Signals automatisch einzustellen. Der Analog/Digital-Wandler ADC dient dazu, ein analoges Signal in eine digitales Signal umzuwandeln. Die digitale Signalverarbeitungseinheit DSP analysiert neben anderen Signalverarbeitungsaufgaben den Eingangssignalpegel und steuert das digital einstellbare Potentiometer DCP. Die Steuerung erfolgt insbesondere, um eine optimale Aussteuerung des Analog/Digital-Wandlers ADC vorzunehmen. Eine mögliche Änderung des Eingangssignalpegels an dem analogen Eingang Al kann durch die Einstellung des digital einstellbaren Potentiometers DCP kompensiert werden. Die Einstellung des digital einstellbaren Potentiometers wird in der digitalen Signalverarbeitungseinheit DSP berechnet. Insbesondere kann dies derart realisiert werden, dass die Transferfunktion zwischen Ein- und Ausgang immer dieselbe Größe aufweist. Dies wird durch die Kompensation der eingestellten Verstärkung durch den Digitalpotentiometer DP in der Signalverarbeitungseinheit DSP ausgeführt. Dabei ist es gleichgültig, ob hier ein digitales Potentiometer nachgebildet wird oder ob die Kompensation durch einen Multiplizierer oder in anderer Form dargestellt wird. Es kommt allein darauf an, dass die Kompensation so genau erfolgt, dass keine zusätzlichen Störungen des Audiosignals erzeugt werden. Das Ausgangssignal kann als ein analoges Ausgangssignal AO und/oder ein digitales Ausgangssignal DO vorliegen.

Sofern die Einstellung des Eingangssignals mit dem Potentiometer DCP über einen ausreichend großen Bereich geschieht, kann bei derartigen Systemen auf ein (weiteres) manuell verstellbares Eingangspotentiometer (Eingangssteller) komplett verzichtet werden. Dies stellt gerade bei drahtlosen Mikrofonsystemen und Taschensendern für den Bühneneinsatz einen enormen Vorteil dar.

Fig. 3 zeigt ein Blockschaltbild einer digitalen Signalverarbeitung gemäß einem zweiten Beispiel. Die Signalverarbeitung gemäß dem zweiten Beispiel kann auf der Signalverarbeitung gemäß dem ersten Beispiel beruhen. Anstatt der internen Pegelkompensation DP in der digitalen Signalverarbeitungseinheit gemäß dem ersten Ausführungsbeispiel wird in dem zweiten Beispiel eine Pegeleinstellung innerhalb des Digital/Analog-Wandlers DAC vorgenommen (Es gibt Digital/Analog-Wandler mit einem internen digital einstellbaren Potentiometer). Diese Regeleinstellung wird durch die Signalverarbeitungseinheit DSP gesteuert.

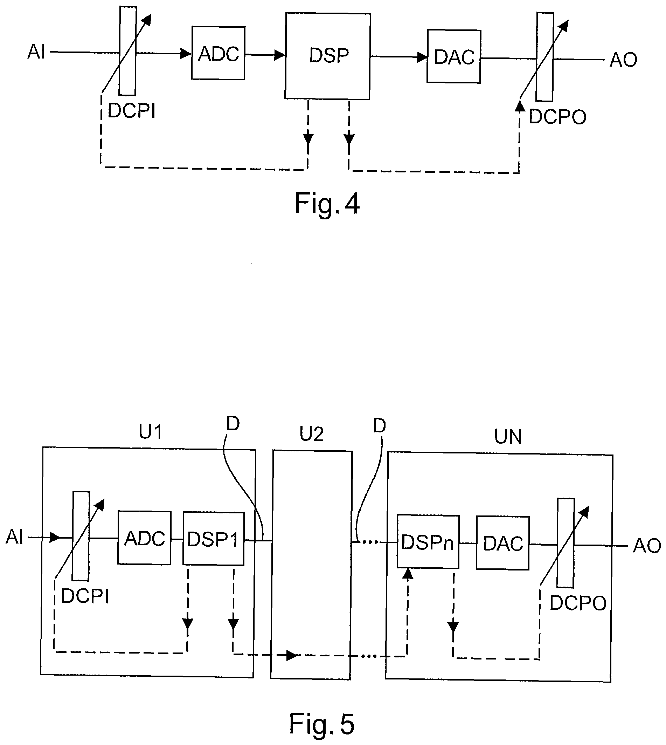

Fig. 4 zeigt ein Blockschaltbild einer Signalverarbeitung gemäß einem dritten Beispiel. Das dritte Beispiel kann auf dem ersten und zweiten Ausführungsbeispiel beruhen. Im Gegensatz zu dem ersten und zweiten Beispiel weist die Signalverarbeitungseinheit DSP gemäß dem dritten Beispiel sowohl ein digital einstellbares Eingangs-Potentiometer DCPI als auch ein digital einstellbare AusgangsPotentiometer DCPO auf, welches spiegelbildlich zum Einstellen der Eingangs-und Ausgangsverstärkung verwendet werden. Die Verstärkung wird von der digitalen Signalverarbeitungseinheit DSP eingestellt.

Das dritte Beispiel berücksichtigt somit nicht nur den analogen Ein-, sondern auch den analogen Ausgang und kann somit zu der optimalen Lösung im Sinne des Signal-Rausch-Abstands führen. Eine Voreinstellung an dem Eingangs-Potentiometer DCPI zur Einstellung der Verstärkung wird entsprechend durch das AusgangsPotentiometer DCPO kompensiert. So bleibt die Verstärkung bzw. Relation zwischen dem Eingangs- und Ausgangssignal über die ganze Verarbeitungskette konstant. Dieses Beispiel mit einem digital verstellbaren analogen Eingangs- und Ausgangspotentiometer stellt im Sinne des Signal-Rausch-Abstands die optimale Lösung dar. Dies ist in der Tatsache begründet, dass das Nachbilden eines Potentiometers in der digitalen Domäne (siehe DP in Fig. 2) immer das Abschneiden von aktiven Bits zur Folge hat und somit zu einem Dynamikverlust von 6dB/Bit führt. Die Kompensation auf der analogen Ebene (siehe DCPO in Fig. 4) führt zu kleineren Verlusten im Dynamikbereich.

Fig. 5 zeigt ein Blockschaltbild einer Signalverarbeitung gemäß einem vierten Beispiel und beruht auf dem dritten Beispiel. Es besteht aus einer Kette signalverarbeitenden Einheiten U1 bis UN (dies kann eine Kette von Geräten sein). Die erste Einheit U1 enthält einen Analog/Digital-Wandler (ADC), die weiteren (U2, U3 usw.) haben je einen digitalen Ein- und Ausgang, die letzte Einheit UN enthält einen Digital/Analog-Wandler (DAC). Die erste Einheit enthält gemäß der Erfindung die automatische Einstellung einer optimalen Verstärkung bzw. Empfindlichkeit, die garantiert, dass die Einheiten U2, U3 usw. und schließlich die letzte Einheit UN optimal ausgesteuert werden. Die Kompensation der Verstärkung im Sinne des Ausführungsbeispiels in Fig. 2 (dort mit dem digitalen Potentiometer DP implementiert) wird hier systemübergreifend mit einem digital einstellbaren Ausgangspotentiometer DCPO realisiert. Das Kompensationssignal wird synchronisiert an die letzte Einheit UN übertragen. Der Wert der Kompensation kann z. B. in dem Hauptsignal eingebettet sein. In der letzten Einheit UN wird das Kompensationssteuersignal an das digital verstellbare Ausgangspotentiometer DPCO UN ausgegeben.

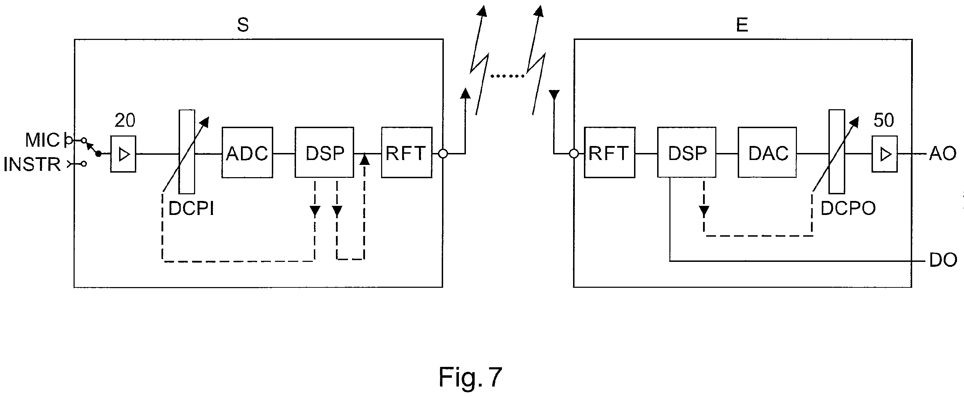

Das vierte Beispiel (Fig. 5) kann z. B. als ein Drahtlos-Mikrofonsystem mit einem Sender und einem Empfänger ausgestaltet sein. Hierbei kann dann die erste Einheit U1 als ein Drahtlos-Mikrofon und die letzte Einheit als ein Drahtlos-Empfänger ausgestaltet sein. So kann ein Drahtlos-System, bestehend aus einem Sender und einem Empfänger, einschließlich der HF-Übertragung (Hochfrequenz- bzw. RF-Übertragung) über die ganze Strecke hinweg optimal ausgesteuert werden und somit automatisch eine hohe Audioqualität in dem ganzen zur Verfügung stehenden Dynamikbereich garantieren (siehe später Fig. 7). Im allgemeinen Fall können die Einheiten U2 bis U(N-1)rein digitale Signalverarbeitungsgeräte sein, die in dieser Anordnung auch automatisch optimal ausgesteuert werden. Das durch die Schalterstellung des Eingangspotentiometer DCPI in den richtigen Dynamikbereich gebrachte Eingangssignal mit der akustischen Information wird von der ersten Einheit U1 an die nächste Einheit usw. bis zur letzten Einheit UN weitergegeben, wobei jede Einheit das Nutzsignal bestimmungsgemäß verarbeitet und dieses verarbeitete Signal an die folgende Einheit UX weitergibt. Zusätzlich wird die Stellung des Eingangspotentiometers DCPI von der ersten Einheit U1 an die letzte Einheit UN übertragen, damit das (dann mehrfach verarbeitete) Signal von dieser durch die quasi spiegelbildliche Verstellung des Ausgangspotentiometers DCPO wieder in den gewünschten (Original-)Dynamikbereich gebracht werden kann. Eine Verschiebung des Dynamikbereichs in den zwischengeschalteten Einheiten U2 bis U(N-1) ist nicht erforderlich, da dieser durch das beschriebene Verfahren in dem für die digitale Verarbeitung optimalen Bereich liegt. Die Information über die Stellung des Eingangspotentiometers DCPI kann auch mit in das akustische Nutzsignal eingebettet werden; es muss nicht zwangsläufig über einen getrennten Kanal an die letzte Einheit weitergegeben werden.

Zur weiteren Verbesserung der Qualität der erfindungsgemäßen Audioverarbeitung sollte sichergestellt werden, dass die digital einstellbaren Eingangs- und AusgangsPotentiometer eine ausreichende Anzahl von Schaltstufen zur Verfügung haben, um beispielsweise Schaltklicks zu vermeiden. Die Potentiometerstufen können beispielsweise eine logarithmische oder zumindest quasi-logarithmische Charakteristik haben. Optional kann eine Kalibrierung der Stufen erfolgen, wenn günstige Potentiometer mit größerer Toleranz zwischen den Exemplaren zu verwenden sind. Unter Kalibrierung wird dabei verstanden, dass die genauen Werte der Potentiometer im Ein- und Ausgang für jede Schaltstufe einzeln ermittelt werden. Dadurch ist es möglich, statt des eingestellten Wertes den exakt ermittelten Wert in der Verarbeitung zu berücksichtigen. Dies dient auch bei hochwertigen Potentiometern (mit geringer Toleranz) einer weiteren Erhöhung der Genauigkeit und somit zu einer Qualitätssteigerung, kann andererseits aber auch dazu genutzt werden, preiswertere Bauteile zu verwenden, die im Allgemeinen stärkere Abweichungen vom idealen Verlauf haben als höherpreisige Bauteile. Ein solcher Kalibrierungsprozess kann für Potentiometer mit beliebigem Kurvenverlauf erfolgen, also speziell für lineare, logarithmische oder quasi-logarithmische. Dieser Kalibriervorgang kann beispielsweise automatisch gesteuert durch die Signalverarbeitungseinheit DSP erfolgen. Wird von dieser automatischen Vermessung Gebrauch gemacht, kann man den Kalibrierungsprozess in gewissen Abständen wiederholen lassen, z. B. jeweils beim Einschalten der Anlage (Initialisierungsprozess); durch diese Maßnahme kann man zeitbedingten Änderungen der Bauteile (Alterung) entgegenwirken, der bekanntenmaßen gerade Analogbauteile in wesentlich stärkerem Maße unterliegen als digitale. Hierdurch erreicht man auch im analogen Teil des Systems eine von professionellen Anwendern geforderte Langzeitstabilität.

Zur weiteren Verbesserung der Audiosignalqualität kann der Schaltvorgang zwischen zwei Stufen des digital gesteuerten Potentiometers mit einem Signalnulldurchgang synchronisiert werden. Ein Nulldurchgang stellt dabei den Zeitpunkt dar, zu dem die Amplitude des analogen Signals die x-Achse kreuzt, d. h. Null ist. Wenn beispielsweise eine Änderung der Verstärkung des Potentiometers genau zu diesem Zeitpunkt (d. h. der Signalpegel ist sehr niedrig) erfolgt, dann sind die ggf. auftretenden Schaltartefakte nicht hörbar. Sobald das digitale Potentiometer dagegen in einem beliebigen Zeitpunkt umgeschaltet wird, kann dies einen hörbaren negativen Effekt haben (bspw. Klick).

Das Steuersignal von der digitalen Signalverarbeitungseinheit DSP zu dem Eingangspotentiometer muss unter Berücksichtigung aller relevanten Verzögerungen in der Schnittstelle zwischen der digitalen Signalverarbeitungseinheit DSP und dem digital einstellbaren Potentiometer synchronisiert sein.

Die Verstärkungsänderungen in dieser automatischen Regelung sollten relativ langsam und geschmeidig erfolgen im Vergleich zu ansonsten üblichen dynamischen Prozessoren wie sie durch einen Kompressor, Expander oder Limiter erfolgen. Gemäß der Erfindung werden die Mikro- und Makrodynamik im Wesentlichen unbeeinflusst gelassen, insbesondere bei Signalen, wo transiente Verzerrungen zu vermeiden sind. Dies sollte insbesondere bei einer hochqualitativen Audioverarbeitung erfolgen.

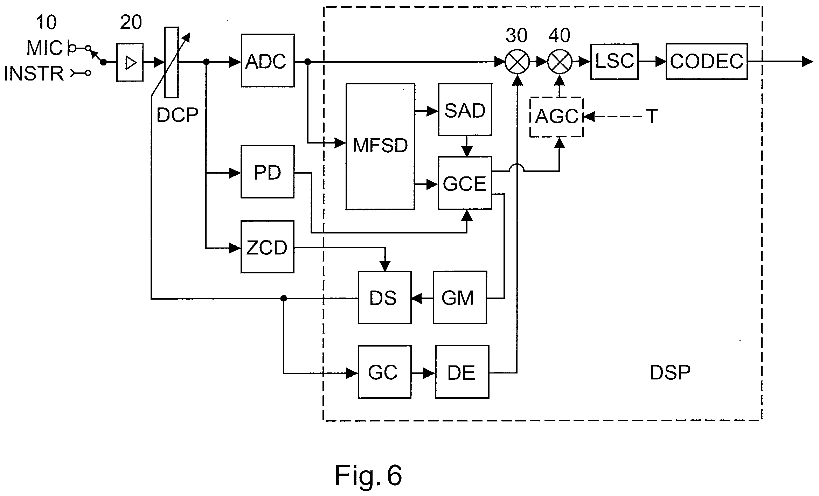

Fig. 6 zeigt ein schematisches Blockschaltbild einer Signalverarbeitung die ein erfindungsgemäßes Ausführungsbeispiel darstellt und in den Beispielen (Fig. 2, 3, 4, 5 und 7) angewendet werden kann. Die Signalverarbeitung in Fig. 6 ist typisch für ein Drahtlos-Mikrofon in Form eines Handmikrofons oder als ein Taschensender ausgestaltet. Der Taschensender kann mit einem Mikrofon verbunden sein und Gesang oder Musik erfassen. Optional kann am Eingang ein Schalter 10 vorgesehen sein, wobei entweder ein Mikrofon MIC oder ein Instrument INSTR am analogen Eingang angeschlossen sein kann. Das analoge Eingangsaudiosignal kann durch einen Vorverstärker 20 verstärkt werden und kann dann einem digital einstellbaren Potentiometer DCP zugeführt werden. Das Ausgangssignal des digitalen Potentiometers DCP wird einem Analog/Digital-Wandler ADC zugeführt. Am Ausgang des Analog/Digital-Wandlers ADC ist ein Multifunktional-Signaldetektor MFSD vorgesehen, der optional die Signaleigenschaften des Audiosignals analysiert. Die analysierten Signaleigenschaften des Audiosignals werden einem Signalaktivitätsdetektor SAD zugeführt, welcher dazu dient, ein Nutzsignal zu erkennen. Das Ausgangssignal des Signaldetektors MFSD wird ebenfalls einer Berechnungseinheit GCE (engl. gain calculation) zugeführt, welche einen Verstärkungskorrekturfaktor für das digital einstellbare Potentiometer DCP am Eingang berechnet. Dieser Verstärkungskorrekturfaktor sollte vorzugsweise einen glatten Signalverstärkungsfaktor darstellen, wofür die Berechnungseinheit GCE sorgt. Das Ausgangssignal des digital einstellbaren Potentiometers DCP (ein analoges Signal) wird dem Spitzenwertdetektor (engl. peak detector) PD zugeführt. Das Ausgangssignal des Spitzenwertdetektors PD wird der Verstärkungsberechnungseinheit GCE zugeführt. Falls der Spitzenwertdetektor PD einen Spitzenwert erfasst hat, welcher oberhalb des Grenzwertes liegt, dann wird ein entsprechendes Signal ausgegeben, das durch die Verstärkungsberechnungseinheit GCE erfasst wird und dazu führt, dass die Verstärkung des digital einstellbaren Potentiometers DCP schnell (quasi sofort, ohne weitere Verzögerung) reduziert wird. Dies erfolgt insbesondere, wenn ein unerwarteter Signalanstieg hinter dem Potentiometer aufgetreten ist. Der Signalaktivitätsdetektor SAD steuert einen Anstieg bzw. einen Abfall der Verstärkung des digitalen Potentiometers DCP in Abhängigkeit des Vorhandenseins oder der Abwesenheit eines gewünschten Signals (Nutzsignals).

Insbesondere in zwei Fällen soll eine besondere Bearbeitung vorgenommen werden, nämlich wenn der Signalpegel nach dem Potentiometer extrem schnell ansteigt oder wenn das gewünschte Signal am Eingang nicht mehr vorhanden ist. Ein Pegelsteueralgorithmus der digitalen Signalverarbeitungseinheit DSP folgt der Tendenz des Eingangssignals und kann eine unerwartete Erhöhung des Eingangssignals im Regelfall verhindern. Andererseits können auch Fälle vorhanden sein, wo ein unerwartet hoher Anstieg des Signalpegels (beispielsweise Störungen wie Klicks oder Rumpeln) auftritt, welcher nicht durch den Steueralgorithmus im Normalmodus kompensiert werden kann. Zur Vermeidung einer harten Begrenzung der Signale in dem Digital/Analog-Wandler DAC kann ein analoger Spitzenwertdetektor PD (engl. peak detector) an dem Ausgang des digital einstellbaren Potentiometers vorhanden sein. Das Ausgangssignal des Spitzenwertdetektors kann als ein Steuersignal für den Steueralgorithmus in der digitalen Signalverarbeitungseinheit (GCE) verwendet werden. Ferner kann das Ausgangssignal des Spitzenwertdetektors dazu verwendet werden, die Verstärkung durch das digital einstellbare Potentiometer schnell zu reduzieren. Ein derartiger Eingriff in den Steueralgorithmus ist hinsichtlich der Audiosignalqualität besser als die durch das harte Begrenzen in dem Analog/Digital-Wandler ADC hervorgerufenen hörbaren Verzerrungen. Um ausreichend schnell zu sein, kann dieser Vorgang ggf. schnelle Interrupt-Eingänge des DSP nutzen. Dieser Vorgang ist nicht an die getaktete Verarbeitung des Nutzsignals durch den Analog/Digital-Wandler gekoppelt und unterliegt daher auch nicht der für diesen Teil der Verarbeitung geltenden zeitlichen Verzögerungen. Alternativ lässt sich dieser Funktionsteil (anders als in der Zeichnung dargestellt) auch außerhalb des DSP durch eine getrennte Hardware realisieren.

Bei dem anderen oben beschriebenen Fall kann es vorkommen, dass kein Audiosignal mehr am Eingang vorhanden ist. Dies kann beispielsweise dann geschehen, wenn ein Sprecher oder Sänger gerade aufgehört hat zu sprechen oder zu singen. In einem derartigen Fall kann es dazu kommen, dass die Eingangsverstärkung automatisch immer weiter erhöht wird. Dies führt aber auch dazu, dass unerwünschte Signale und damit auch das Rauschen verstärkt werden und hörbar werden. Wenn dann der Sänger oder Sprecher wieder anfängt zu singen oder zu sprechen, dann kann dies wiederum dazu führen, dass eine massive Übersteuerung in dem Analog/Digital-Wandler ADC vorkommt. Daher kann ein Signalaktivitätsdetektor (engl. signal activity detector) SAD vorgesehen sein, welcher das Eingangssignal bzw. das digitalisierte Eingangssignal überwacht und entscheidet, ob ein gewünschtes Signal (Nutzsignal) am Eingang vorhanden ist oder nicht. Optional kann - statt des Signalaktivitätsdetektors SAD oder zusätzlich zum Signalaktivitätsdetektor SAD -- eine Sprachaktivitätsdetektionseinheit (engl. voice activity detection) VAD vorgesehen sein, wobei darauf zu achten ist, dass diese Einheit lediglich zur Erkennung einer Sprachaktivität ausgelegt ist (in Fig. 6 nicht dargestellt). Eine derartige Einheit kann nicht notwendigerweise andere gewünschte Signale wie beispielsweise Gesang oder musikalische Instrumente erkennen. Optional kann ein Signaldetektor (engl. multi-feature signal detector) MFSD vorgesehen sein, welcher dazu verwendet wird, eine Kombination von verschiedenen Signalcharakteristika zu analysieren. Ferner kann der Signaldetektor dazu verwendet werden, die Parameter dieser Signalcharakteristika hinsichtlich der gewünschten Eingangssignale einzustellen. Der Signaldetektor kann beispielsweise einen Peak-Detektor, einen RMS-Detektor, Nulldurchgangszähler, Signalanstieg-Geschwindigkeitsmesser etc. aufweisen. In Abhängigkeit des Ausgangssignals des Signalaktivitätsdetektors SAD kann ein Anstieg des Pegels am Eingang gestoppt werden, wenn der Signalaktivitätsdetektor SAD erkennt, dass kein gewünschtes Signal am Eingang anliegt.

Das Ausgangssignal der Verstärkungsberechnungseinheit GCE kann einem Verstärkungsmappingmodul GM (engl. gain map) zugeführt werden, welches die exakten Werte des digitalen Potentiometers gespeichert hat, die während eines Kalibrierungsverfahrens gemessen worden sind. Die gewünschten Änderungen der Verstärkung des digital einstellbaren Potentiometers DCP werden allerdings lediglich an das Potentiometer übermittelt, wenn ein Nulldurchgangsdetektor ZCD (engl. zero cross detector) einen entsprechenden Nulldurchgang erfasst hat. Dieser Nulldurchgang wird von dem Nulldurchgangsdetektor ZCD an eine Potentiometer-Synchronisationseinheit DS weitergeleitet, welche an ihrem Eingang mit dem Ausgang des Verstärkungsmappingmoduls GM (engl. gain map) gekoppelt ist.

Der Wert des digital einstellbaren Potentiometers DCP kann zur Verstärkungskompensation des digitalen Potentiometers 30 in der digitalen Signalverarbeitungseinheit DSP einbezogen werden. Das digitale Potentiometer 30 wird vom Ausgang der Potentiometer-Synchronisationseinheit DS über ein Verstärkungs-Anpassglied GC (engl. gain converter) und eine Verzögerung DE (engl. delay) so angesteuert, dass es die korrekte Amplitude zum passenden Zeitpunkt (Synchronisation) einstellt. Die Kompensationsschritte in dem digitalen Potentiometer 30 am Ausgang sind entgegengesetzt (spiegelbildlich) zu denen des digital einstellbaren Potentiometers DCP am Eingang. Damit kann auch ein zusätzlicher fester Verstärkungsfaktor zwischen dem digital einstellbaren Potentiometer am Eingang DCP und dem digitalen Potentiometer 30 am Ausgang ermöglicht werden, wodurch ein konstanter Verstärkungsfaktor zwischen dem Ein- und Ausgang ohne eine Verschlechterung der Qualität durch den Steueralgorithmus vorgesehen sein kann. Die Art der Realisierung des Potentiometers 30 ist dabei gleichgültig (s.o.) - es kommt lediglich darauf an, die Verstärkung zu kompensieren, ohne dabei das Signal zu verfälschen.

Der Signaldetektor MFSD errechnet Steuersignale, welche von einer automatischen Verstärkungssteuereinheit (engl. automatic gain control) AGC verwendet werden können, um die Dynamik des Signals zu ebnen. Dies erfolgt beispielsweise durch die Reduzierung der Lautstärke von lauten Signalen und die Anhebung von leisen Signalen. Dies kann optional basierend auf gewünschten Zielvorgaben (engl. target) T erfolgen. Die automatische Verstärkungssteuereinheit AGC kann verwendet werden, um die Verstärkung nicht zu erhöhen, wenn längere Pausen in dem gewünschten Signal vorhanden sind. Dies kann beispielsweise erfolgen, wenn der Sprecher für einen längeren Zeitraum aufhört zu sprechen. Hierzu ist es jedoch vorteilhaft, wenn eine zuverlässige Signalaktivitätsdetektion erfolgen kann. Da gemäß der Erfindung bereits ein Signalaktivitätsdetektor SAD vorhanden ist, kann dieser mit der Verstärkungssteuereinheit AGC gekoppelt werden. Die Verstärkungssteuereinheit AGC wirkt über das digitale Potentiometer 40 auf das digitale Nutzsignal ein. Die Art der Realisierung des Potentiometers 40 ist gleichgültig (s.o.), solange keine Signalverfälschung erfolgt.

Optional kann eine Limiter/Softclip-Einheit LSC vorgesehen sein. Diese Einheit dient dazu, das Ausgangssignal zu begrenzen und ggf. sanft abzuschneiden, wenn beispielsweise aufgrund einer unerwarteten Signaländerung es zu einer Übersteuerung in der digitalen Signalverarbeitungseinheit gekommen ist. Vorzugsweise erfolgt diese Begrenzung, bevor das digitale Signal einem digitalen Codec zugeführt wird und anschließend drahtlos mittels eines Hochfrequenz-Senders HF übertragen wird, da eine Übersteuerung im Codec in der Regel zu deutlich hörbaren Signalverfälschungen führt. Ein Codec ist ein übliches Verfahren, digitale Signale zu kodieren und zu dekodieren (engl. code/decode). Durch die vorgestellte Erfindung profitieren auch die Codecs vom Prozess der Dynamikoptimierung: die Erfindung erlaubt auch Codecs mit relativ kleinem Dynamikumfang (und damit sehr preiswerte) in professionellen Systemen zu nutzen. Der Codec kann vorteilhafterweise im DSP mit realisiert werden, er selbst ist nicht Teil der Erfindung, sondern bekannt (Stand der Technik). Statt ihn im DSP mit zu implementieren (als Software) kann dieser jedoch auch als eigenständige (integrierte) Schaltung verwirklicht werden. Eine weitere digitale Signalverarbeitung (z.B. Filterung) kann - wenn sie mit im DSP implementiert werden soll - je nach Zweckmäßigkeit zwischen den Potentiometern 30 und 40, zwischen dem Potentiometer 30 und dem Limiter LSC, zwischen dem Limiter LSC und dem Codec oder nach dem Codec erfolgen.

Fig. 7 zeigt ein schematisches Blockschaltbild eines Drahtlos-Mikrofonsystems gemäß einem fünften Beispiel. In Fig. 7 ist ein Drahtlos-Sender S und ein Drahtlos-Empfänger E gezeigt. Der Drahtlos-Sender S kann als ein Drahtlos-Mikrofon ausgestaltet sein und überträgt ein Audiosignal über eine drahtlose Strecke. Der Drahtlos-Empfänger E empfängt das drahtlos übertragene Audiosignal und führt es einer entsprechenden Signalverarbeitung zu. Der Sender S gemäß dem fünften Beispiel kann beispielsweise auf der Signalverarbeitungseinheit gemäß dem Blockdiagramm Fig. 6 beruhen. In dem Sender ist ein Hochfrequenz-Sender RFT (engl. radio frequency transmitter) vorgesehen, welcher dazu dient, das digitale und verarbeitete Audiosignal drahtlos zu übertragen. In dem Empfänger E ist ein Hochfrequenz-Empfänger RFR (engl. radio frequency receiver) vorgesehen, um das drahtlos übertragene Audiosignal zu empfangen. In dem Sender S wird die Verstärkung des digital einstellbaren Potentiometers am Eingang DCPI durch die Signalverarbeitungseinheit DSP gesteuert. Dies erfolgt wie in dem ersten, zweiten, dritten oder vierten Beispiel und wie im Blockdiagramm Fig. 6 beschrieben. Entsprechendes gilt für den Empfänger, wo die Verstärkung des digital einstellbaren Potentiometers DCPO am Ausgang durch die Signalverarbeitungseinheit DSP im Empfänger gesteuert wird. Damit wird der Analog/Digital-Wandler sowie ein digitaler Datenencoder in dem Sender optimal ausgesteuert und zwar wie gemäß den vorhergehenden Beispielen beschrieben. Gemäß der Erfindung werden der Datenencoder und der Datendecoder ebenfalls innerhalb der Signalverarbeitung realisiert und profitieren somit vom Vorteil der optimalen Dynamikausnutzung gemäß der Erfindung. Dies ist vorteilhaft, weil somit ebenfalls preisgünstigere Codecs (mit kleinerem spezifiziertem Dynamikbereich) verwendet werden können, ohne dabei die Qualität der Audioübertragung zu begrenzen. Diese automatische Dynamikoptimierung umfasst in einem Drahtlos-Mikrofonsystem auch die Hochfrequenz-Module, den Sender, die HF-Übertragungsstrecke und den Empfänger. Diese werden ebenfalls optimal ausgesteuert und optimal moduliert, was die Zuverlässigkeit, akustische Qualität und die maximale mögliche Entfernung (Abstand zwischen den Antennen von dem Sender und dem Empfänger) eines drahtlosen Systems erhöht.

Die digitale Signalverarbeitungseinheit kann durch einen digitalen Signalprozessor dargestellt werden. Alternativ dazu kann die digitale Signalverarbeitungseinheit aber auch aus einem FPGA, einem Mikroprozessor, einem Computer oder einer sonstigen integrierten Schaltung bestehen.

Das erfindungsgemäße Verfahren ermöglicht eine optimale Nutzung des Dynamikbereichs des Systems. Dies erfolgt durch Anpassung der analogen Verstärkung am Eingang des Systems und zwar so, dass möglichst viele Bits in dem Analog/Digital-Wandler und der nachfolgenden Signalverarbeitung genutzt werden können. Am Ausgang wird diese Verschiebung kompensiert, so dass der Ausgangspegel bezogen auf den Eingangspegel unabhängig von der Dynamikverschiebung innerhalb des Systems gleich bleibt und somit eine konstante Gesamtverstärkung ermöglicht. Es geht darum, dass das System versucht, automatisch die maximal mögliche Anzahl von Bits des Systems zu nutzen, und zwar unabhängig davon, ob die Amplitude des Eingangssignals klein oder groß ist. So wird der Signal-Rausch-Abstand des Systems permanent optimiert und somit im Rahmen der zur Verfügung stehenden Systemdynamik stets maximiert. Gleichzeitig wird durch eine erfindungsgemäße Systemauslegung ermöglicht, die Hochfrequenz-Strecke optimal auszunutzen. Auch diese hat einen begrenzten Dynamikbereich, in dem eine störungsfreie Übertragung möglich ist. Dieser Bereich wird nach unten (kleine Leistungen) durch das Rauschen und Störungen im Hochfrequenzbereich bestimmt, nach oben (hohe Leistungen) u. a. durch die zur Verfügung stehende oder die der Vorschriften nach zulässigen HF-Leistung.

Wenn beispielsweise ein schwaches Eingangssignal lediglich vier Bits des Analog/DigitalWandlers aussteuert, dann kann die nachfolgende Signalverarbeitung nicht mehr als eine 24 dB Dynamik aufweisen, wenn man von einer Dynamik von 6 dB/Bit ausgeht. Wenn jedoch erfindungsgemäß die Aussteuerung am Eingang des digital einstellbaren Potentiometers auf z. B. 12 Bits erhöht wird, dann kann die nachfolgende Signalverarbeitung mit einer Dynamik von 72 dB erfolgen. Es sei darauf hingewiesen, dass hierdurch das Signal-Rausch-Verhältnis des Eingangssignals nicht verbessert werden kann, wenn das Eingangssignal einen eigenen niedrigeren Signal-Rausch-Abstand aufweist. Es wird jedoch davon ausgegangen, dass die analogen Vorverstärker Stufen eine größere Dynamikreserve aufweisen als preiswerte Analog/Digital-Wandler. Wenn das Eingangssignal die Aussteuerungsgrenze des Analog/Digital-Wandlers überschreiten sollte, dann würde die Verstärkung an dem digital einstellbaren Eingangspotentiometer DCPI verringert, um Verzerrungen zu vermeiden. Diese Verstärkungsänderung am Eingang kann dann entsprechend durch das digital einstellbare Potentiometer am Ausgang DCPO kompensiert werden.

Gemäß der Erfindung sollte die Regelung des erfindungsgemäßen Verfahrens entsprechend sanft eingestellt sein, so dass nicht nur die Makro-, aber auch die Mikrodynamik des Systems erhalten bleibt. Dies ist insbesondere bei hochwertigen Audioübertragungssystemen im Hinblick auf das Transientenverhalten der Signale notwendig.

Gemäß einem Aspekt der vorliegenden Erfindung können die Signallaufzeiten zum Ansteuern des digitalen Potentiometers DP oder des digital einstellbaren Potentiometers DCPO auch auf die Zeit der Wandler ADC, DAC bei der Regelung berücksichtigt werden.

Gemäß einem weiteren Aspekt der vorliegenden Erfindung muss, wenn die digitale Signalverarbeitung DSP den Wert des digitalen Eingangspotentiometers DCPI ändern will, dies zunächst verarbeitet werden. Zusätzlich dazu kann die Übertragung der neuen Position an das Potentiometer einige Zeit, beispielsweise wenige Mikrosendungen, dauern. Wenn die Werte des digitalen Eingangspotentiometers DCPI verstellt sind, so wirkt sich dies zunächst lediglich auf die analogen Signale aus. Das Signal muss dann noch zusätzlich den Analog/Digital-Wandler und die weiteren Funktionsblöcke durchlaufen, bevor das veränderte Signal an dem digitalen Potentiometer DP bzw. dem digital einstellbaren Potentiometer DCPO anliegt und dort kompensiert werden kann. Somit muss bei einer Änderung der Einstellung der Potentiometer auch die zeitliche Abfolge mitberücksichtigen, um glitches zu vermeiden, welche hörbar werden, weil die Kompensation zwar eine Pegelkompensation berücksichtigt, aber dies nicht zeitlich korrekt erfolgt.

Gemäß einem weiteren Aspekt der vorliegenden Erfindung wird insbesondere bei einem System, das eine dynamische zeitliche Varianz aufweist (group delay von Filtern, Verstärkern etc.), muss neben einer Kalibrierung des Pegels auch eine zeitliche Kalibrierung erfolgen.

Gemäß einem weiteren Aspekt der vorliegenden Erfindung können die Blöcke DCPI, DP, DCPO auch als einstellbare Verstärker implementiert werden, wobei die Verstärkung direkt zu steuern ist. Ein Einstellen der Verstärkung kann beispielsweise durch ein .... Modulationssignal PWM erfolgen. Ferner kann ein analoges Steuersignal zum Regeln der Steuerung z. B. voltage controller amplifier, current controlled amplifier regeln. Hierzu kann es nötig sein, einen weiteren Digital-/Analogwandler DAC vorzusehen.

Gemäß einem weiteren Aspekt der vorliegenden Erfindung kann die grundlegende Idee der Erfindung auch auf andere dynamikbegrenzende Signalblöcke oder Pfade ausgeweitet werden. Dies können digitale oder analoge Blöcke darstellen.

## Patentansprüche

1. Digitales Audioübertragungssystem, mit
mindestens einem Drahtlos-Sender (S),
und mindestens einem Drahtlos-Empfänger (E),
wobei der Drahtlos-Sender (S)
einen analogen Eingang (AI),
ein digital einstellbares Eingangspotentiometer (DCPI) zum Einstellen einer Eingangsverstärkung,
einen Peak Detektor (PD),
einen Analog/Digital-Wandler (ADC) mit einer getakteten Verarbeitung zum Wandeln der analogen Signale in digitale Signale, und
eine digitale Signalverarbeitungseinheit (DSP) zum Durchführen einer digitalen Signalverarbeitung aufweist,
wobei die digitale Signalverarbeitungseinheit (DSP) eine Verstärkungsberechnungseinheit (GCE) enthält und dazu ausgestaltet ist, die Eingangsverstärkung einzustellen,
**dadurch gekennzeichnet, dass** dem Peak Detektor (PD) ein analoges Ausgangssignal des digital einstellbaren Eingangspotentiometers (DCPI) zugeführt wird, und der Peak Detektor (PD) bei Erfassung eines Spitzenwertes, der oberhalb eines Grenzwertes liegt, ein Steuersignal über einen Interrupt-Eingang der digitalen Signalverarbeitungseinheit (DSP) an die Verstärkungsberechnungseinheit (GCE) ausgibt, und die Verstärkungsberechnungseinheit (GCE) daraufhin die Eingangsverstärkung durch eine neue Einstellung des digital einstellbaren Potentiometers (DCPI) reduziert, und
wobei die neue Einstellung des digital einstellbaren Eingangspotentiometers (DCPI) durch eine Interrupt-Routine der digitalen Signalverarbeitungseinheit (DSP) erfolgt, sodass die Reduzierung der Eingangsverstärkung nicht an die getaktete Verarbeitung des Analog/Digital-Wandlers (ADC) gekoppelt ist und nicht der zeitlichen Verzögerung der Verarbeitung des Analog/Digital-Wandlers (ADC) unterliegt.

2. Digitales Audioübertragungssystem nach Anspruch 1, wobei die digitale Signalverarbeitungseinheit (DSP) eine Kompensationseinheit (DP, 30) aufweist zur Verstärkung des digitalen Signals mit einem Verstärkungsfaktor, der entgegengesetzt ist zu der Verstärkung des Eingangspotentiometers (DCPI).

3. Digitales Audioübertragungssystem nach Anspruch 1 oder 2, wobei die digitale Signalverarbeitungseinheit (DSP) den Eingangssignalpegel analysiert und wobei die Einstellung der Verstärkung des digitalen Eingangspotentiometers (DCPI) derart erfolgt, dass die Anzahl der effektiven Bits, welche von dem Analog/Digital-Wandler (ADC) und dem nachfolgenden Signalverarbeitungssystem verwendet werden, vergrößert wird.

4. Digitales Audioübertragungssystem nach Anspruch 2, wobei für das digital einstellbare Eingangspotentiometer (DCPI) eine Kalibrierung vorgenommen wird, die Kalibrierwerte gespeichert werden und diese Werte bei der Berechnung der entgegengesetzten Verstärkung durch die Kompensationseinheit (DP, 30) berücksichtigt werden.

5. Digitales Audioübertragungssystem nach Anspruch 4, wobei der Kalibriervorgang von der digitalen Signalverarbeitungseinheit (DSP) automatisch vorgenommen wird.

6. Digitales Audioübertragungssystem nach Anspruch 5, wobei der Kalibriervorgang in festgelegten zeitlichen Abständen automatisch wiederholt wird.

7. Drahtlos-Mikrofon oder drahtloser Taschensender für ein digitales Audioübertragungssystem, mit
einem Drahtlos-Sender (S), der
einen analogen Eingang (AI),
ein digital einstellbares Eingangspotentiometer (DCPI) zum Einstellen einer Eingangsverstärkung,
einen Peak Detektor (PD),
einen Analog/Digital-Wandler (ADC) mit einer getakteten Verarbeitung zum Wandeln der analogen Signale in digitale Signale, und
eine digitale Signalverarbeitungseinheit (DSP) zum Durchführen einer digitalen Signalverarbeitung aufweist,
wobei die digitale Signalverarbeitungseinheit (DSP) eine Verstärkungsberechnungseinheit (GCE) enthält und dazu ausgestaltet ist, die Eingangsverstärkung einzustellen,
**dadurch gekennzeichnet, dass** dem Peak Detektor (PD) ein analoges Ausgangssignal des digital einstellbaren Eingangspotentiometers (DCPI) zugeführt wird, und der Peak Detektor (PD) bei Erfassung eines Spitzenwertes, der oberhalb eines Grenzwertes liegt, ein Steuersignal über einen Interrupt-Eingang der digitalen Signalverarbeitungseinheit (DSP) an die Verstärkungsberechnungseinheit (GCE) ausgibt, und die Verstärkungsberechnungseinheit (GCE) daraufhin die Eingangsverstärkung durch eine neue Einstellung des digital einstellbaren Potentiometers (DCPI) reduziert, und
wobei die neue Einstellung des digital einstellbaren Eingangspotentiometers (DCPI) durch eine Interrupt-Routine der digitalen Signalverarbeitungseinheit (DSP) erfolgt, sodass die Reduzierung der Eingangsverstärkung nicht an die getaktete Verarbeitung des Analog/Digital-Wandlers (ADC) gekoppelt ist und nicht der zeitlichen Verzögerung der Verarbeitung des Analog/Digital-Wandlers (ADC) unterliegt.

8. Drahtlos-Mikrofon oder drahtloser Taschensender nach Anspruch 7, wobei die digitale Signalverarbeitungseinheit (DSP) eine Kompensationseinheit (DP, 30) aufweist zur Verstärkung des digitalen Signals mit einem Verstärkungsfaktor, der entgegengesetzt ist zu der Verstärkung des Eingangspotentiometers (DCPI).

9. Drahtlos-Mikrofon oder drahtloser Taschensender nach Anspruch 8, wobei für das digital einstellbare Eingangspotentiometer (DCPI) eine Kalibrierung vorgenommen wird, die Kalibrierwerte gespeichert werden und diese Werte bei der Berechnung der entgegengesetzten Verstärkung durch die Kompensationseinheit (DP, 30) berücksichtigt werden.

10. Drahtlos-Mikrofon oder drahtloser Taschensender nach einem der Ansprüche 7 - 9, wobei die digitale Signalverarbeitungseinheit (DSP) den Eingangssignalpegel analysiert und wobei die Einstellung der Verstärkung des digitalen Eingangspotentiometers (DCPI) derart erfolgt, dass die Anzahl der effektiven Bits, welche von dem Analog/Digital-Wandler (ADC) und dem nachfolgenden Signalverarbeitungssystem verwendet werden, vergrößert wird.

11. Drahtlos-Mikrofon oder drahtloser Taschensender nach Anspruch 10, wobei der Kalibriervorgang von der digitalen Signalverarbeitungseinheit (DSP) automatisch vorgenommen wird.

12. Drahtlos-Mikrofon oder drahtloser Taschensender nach Anspruch 11, wobei der Kalibriervorgang in festgelegten zeitlichen Abständen automatisch wiederholt wird.

13. Verfahren zum Steuern eines digitalen Drahtlos-Audioübertragungssystems, wobei das Audioübertragungssystem mindestens einen Drahtlos-Sender aufweist,
der einen analogen Eingang (AI), ein digital einstellbares Eingangspotentiometer (DCPI) zum Einstellen einer Eingangsverstärkung, einen Peak Detektor (PD), einen Analog/Digital-Wandler (ADC) mit einer getakteten Verarbeitung zum Wandeln der analogen Signale in digitale Signale, und eine digitale Signalverarbeitungseinheit (DSP) zum Durchführen einer digitalen Signalverarbeitung aufweist, mit dem Schritt:
- automatisches Einstellen der Eingangsverstärkung mittels des digitalen Eingangspotentiometers (DCPI),
wobei die digitale Signalverarbeitungseinheit (DSP) eine Verstärkungsberechnungseinheit (GCE) enthält und dazu ausgestaltet ist, die Eingangsverstärkung einzustellen,
**dadurch gekennzeichnet, dass** dem Peak Detektor (PD) ein analoges Ausgangssignal des digital einstellbaren Eingangspotentiometers (DCPI) zugeführt wird, und der Peak Detektor (PD) bei Erfassung eines Spitzenwertes, der oberhalb eines Grenzwertes liegt, ein Steuersignal über einen Interrupt-Eingang der digitalen Signalverarbeitungseinheit (DSP) an die Verstärkungsberechnungseinheit (GCE) ausgibt, und die Verstärkungsberechnungseinheit (GCE) daraufhin die Eingangsverstärkung reduziert,
wobei die neue Einstellung des digital einstellbaren Eingangspotentiometers (DCPI) durch eine Interrupt-Routine der digitalen Signalverarbeitungseinheit (DSP) erfolgt, sodass die Reduzierung der Eingangsverstärkung nicht an die getaktete Verarbeitung des Analog/Digital-Wandlers (ADC) gekoppelt ist und nicht der zeitlichen Verzögerung der Verarbeitung des Analog/Digital-Wandlers (ADC) unterliegt.

14. Verfahren nach Anspruch 13, mit dem weiteren Schritt
Kompensieren der Verstärkung mit einem Verstärkungsfaktor, der entgegengesetzt ist zu der Verstärkung des Eingangspotentiometers, wobei die digitale Signalverarbeitungseinheit (DSP) eine Kompensationseinheit (DP, 30) aufweist zur Verstärkung des digitalen Signals mit dem zur Verstärkung des Eingangspotentiometers (DCPI) entgegengesetzten Verstärkungsfaktor.

## Claims

1. Digital audio transmission system, comprising
at least one wireless transmitter (S), and
at least one wireless receiver (E),
wherein the wireless transmitter (S) has
an analog input (Al),
a digitally adjustable input potentiometer (DCPI) for adjusting an input gain,
a peak detector (PC),
an analog/digital converter (ADC) with a clocked operation for converting the analog signals into digital signals, and
a digital signal processing unit (DSP) for performing digital signal processing,
wherein the digital signal processing unit (DSP) comprises a gain calculation unit (GCE) and is configured for adjusting the input gain,
**characterized in that**
the peak detector (PD) receives an analog output signal of the digitally adjustable input potentiometer (DCPI) and the peak detector (PD) outputs a control signal over an interrupt input of the digital signal processing unit (DSP) to the gain calculation unit (GCE) upon detecting a maximum value which is above a threshold,
wherein there upon the gain calculation unit (GCE) reduces the input gain by a new setting of the digitally adjustable input potentiometer (DCPI), and
wherein the new setting of the digitally adjustable input potentiometer (DCPI) takes place through an interrupt routine of the digital signal processing unit (DSP), such that the reduction of the input gain is not coupled to the clocked operation of the analog/digital converter (ADC) and does not underlie the time delay of the operation of the analog/digital converter (ADC).

2. Digital audio transmission system according to claim 1, wherein the digital signal processing unit (DSP) comprises a compensation unit (DP, 30) for amplifying the digital signals with a gain factor which is opposite to the gain of the input potentiometer (DCPI).

3. Digital audio transmission system according to claim 1 or 2, wherein the digital signal processing unit (DSP) analyses the input signal level and wherein the setting of the gain of the digital input potentiometer (DCPI) is performed such that the number of effective bits which are used by the analog/digital converter (ADC) and by the subsequent signal processing system, is increased.

4. Digital audio transmission system according to claim 2, wherein a calibration is effected for the digitally adjustable input potentiometer (DCPI), wherein the calibration values are stored and these values are used during the calculation of the opposite gain through the compensation unit (DP, 30).

5. Digital audio transmission system according to claim 4, wherein the calibration operation is performed automatically by the digital signal processing unit (DSP).

6. Digital audio transmission system according to claim 5, wherein the calibration operation is automatically repeated at fixed time intervals.

7. Wireless microphone or wireless pocket transmitter for a digital audio transmission system, comprising
a wireless transmitter (S),
an analog input (Al),
a digitally adjustable input potentiometer (DCPI) for adjusting an input gain,
a peak detector (PC),
an analog/digital converter (ADC) with a clocked operation for converting the analog signals into digital signals, and
a digital signal processing unit (DSP) for performing digital signal processing,
wherein the digital signal processing unit (DSP) comprises a gain calculation unit (GCE) and is configured for adjusting the input gain,
**characterized in that**
the peak detector (PD) receives an analog output signal of the digitally adjustable input potentiometer (DCPI) and the peak detector (PD) outputs a control signal over an interrupt input of the digital signal processing unit (DSP) to the gain calculation unit (GCE) upon detecting a maximum value which is above a threshold,
wherein there upon the gain calculation unit (GCE) reduces the input gain by a new setting of the digitally adjustable input potentiometer (DCPI), and
wherein the new setting of the digitally adjustable input potentiometer (DCPI) takes place through an interrupt routine of the digital signal processing unit (DSP) such that the reduction of the input gain is not coupled to the clocked operation of the analog/digital converter (ADC) and does not underlie the time delay of the operation of the analog/digital converter (ADC).

8. Wireless microphone or wireless pocket transmitter according to claim 7, wherein the digital signal processing unit (DSP) comprises a compensation unit (DP, 30) for amplifying the digital signals with a gain factor which is opposite to the gain of the input potentiometer (DCPI).

9. Wireless microphone or wireless pocket transmitter according to claim 8, wherein a calibration is performed for the digital adjustable input potentiometer (DCPI), wherein the calibration values are stored and these values are used for calculating the opposite gain through the compensation unit (DP, 30).

10. Wireless microphone or wireless pocket transmitter according to anyone of the claims 7 to 9, wherein the digital signal processing unit (DSP) analyses the input signal level and wherein the setting of the gain of the digital input potentiometer (DCPI) is performed such that the number of effective bits which are used by the analog/digital converter (ADC) and by the subsequent signal processing system is increased.

11. Wireless microphone or wireless pocket transmitter according to claim 10, wherein the calibration operation is automatically performed by the digital signal processing unit (DSP).

12. Wireless microphone or wireless pocket transmitter according to claim 11, wherein the calibration operation is automatically repeated at fixed time intervals.

13. Method of controlling a digital wireless audio transmission system, wherein the audio transmission system comprises at least one wireless transmitter, which comprises an analog input (Al), a digital adjustable input potentiometer (DCPI) for adjusting an input gain, a peak detector (PD), an analog/digital converter (ADC) with a clocked operation for converting the analog signal into digital signals, and a digital signal processing unit (DSP) for performing a digital signal processing, comprising the step:
automatically adjusting an input gain with the digital input potentiometer (DCPI),
wherein the digital signal processing unit (DSP) comprises a gain calculating unit (GCE) and is adapted for adjusting an input gain,
**characterized in that** an analog output signal of the digitally adjustable input potentiometer (DCPI) is supplied to the peak detector (PD), and the peak detector (PD) outputs a control signal via an interrupt input of the digital signal processing unit (DSP) to the gain calculating unit (GCE) upon detecting a maximum value which is above a threshold value and thereupon the gain calculating unit (GCE) reduces the input gain,
wherein the new setting of the digitally adjustable input potentiometer (DCPI) takes place through an interrupt routine of the digital signal processing unit (DSP) such that a reduction of the input gain is not coupled to the clocked operation of the analog/digital converter (ADC) and is not underlie the time delay of the operation of the analog/digital converter (ADC).

14. Method according to claim 13 with the additional step:
compensating the gain with a gain factor which is opposite to the gain of the input potentiometer, wherein the digital signal processing unit (DSP) comprises a compensation unit (DP, 30) for amplifying the digital signals with the gain factor which is opposite to the gain of the input potentiometer (DCPI).

## Revendications

1. Système de transmission audio numérique, avec
au moins un émetteur sans fil (S),
et au moins un récepteur sans fil (E),
dans lequel le récepteur sans fil (S) présente
une entrée analogique (AI),
un potentiomètre d'entrée à réglage numérique (DCPI) servant à régler une amplification d'entrée,
un détecteur de crête (PD),
un convertisseur analogique/numérique (ADC) avec un traitement cadencé servant à convertir les signaux analogiques en signaux numériques, et
une unité de traitement de signaux numérique (DSP) servant à mettre en œuvre un traitement de signaux numérique,
dans lequel l'unité de traitement de signaux numérique (DSP) contient une unité de calcul d'amplification (GCE) et est configurée pour régler l'amplification d'entrée,
**caractérisé en ce qu'**un signal de sortie analogique du potentiomètre d'entrée à réglage numérique (DCPI) est associé au détecteur de crête (PD), et le détecteur de crête (PD) envoie, lors de la détection d'une valeur de crête, qui est supérieure à une valeur limite, un signal de commande par l'intermédiaire d'une entrée d'interruption de l'unité de traitement de signaux numérique (DSP) à l'unité de calcul d'amplification (GCE), et l'unité de calcul d'amplification (GCE) réduit par la suite l'amplification d'entrée par un nouveau réglage du potentiomètre à réglage numérique (DCPI), et
dans lequel le nouveau réglage du potentiomètre d'entrée à réglage numérique (DCPI) est effectué par une routine d'interruption de l'unité de traitement de signaux numérique (DSP) de sorte que la réduction de l'amplification d'entrée n'est pas couplée au traitement cadencé du convertisseur analogique/numérique (ADC) et n'est pas soumise au décalage dans le temps du traitement du convertisseur analogique/numérique (ADC).

2. Système de transmission audio numérique selon la revendication 1, dans lequel l'unité de traitement de signaux numérique (DSP) présente une unité de compensation (DP, 30) servant à amplifier le signal numérique avec un facteur d'amplification, qui est opposé à l'amplification du potentiomètre d'entrée (DCPI).

3. Système de transmission audio numérique selon la revendication 1 ou 2, dans lequel l'unité de traitement de signaux numérique (DSP) analyse le niveau de signal d'entrée et dans lequel le réglage de l'amplification du potentiomètre d'entrée numérique (DCPI) est effectué de telle manière que le nombre des bits effectifs, lesquels sont utilisés par le convertisseur analogique/numérique (ADC) et le système de traitement de signaux suivant, est augmenté.

4. Système de transmission audio numérique selon la revendication 2, dans lequel est effectué pour le potentiomètre d'entrée à réglage numérique (DCPI) un étalonnage, les valeurs d'étalonnage sont mémorisées et ces valeurs sont prises en compte lors du calcul de l'amplification opposée par l'unité de compensation (DP, 30).

5. Système de transmission audio numérique selon la revendication 4, dans lequel l'opération d'étalonnage est réalisée automatiquement par l'unité de traitement de signaux numérique (DSP).

6. Système de transmission audio numérique selon la revendication 5, dans lequel l'opération d'étalonnage est répétée de manière automatique à des intervalles fixés dans le temps.

7. Microphone sans fil ou émetteur de poche sans fil pour un système de transmission audio numérique, avec
un émetteur sans fil (S), qui présente
une entrée analogique (AI),
un potentiomètre d'entrée à réglage numérique (DCPI) servant à régler une amplification d'entrée,
un détecteur de crête (PD),
un convertisseur analogique/numérique (ADC) avec un traitement cadencé servant à convertir les signaux analogiques en signaux numériques, et
une unité de traitement de signaux numérique (DSP) servant à mettre en œuvre un traitement de signaux numérique,
dans lequel l'unité de traitement de signaux numérique (DSP) contient une unité de calcul d'amplification (GCE) et est configurée pour régler l'amplification d'entrée,
**caractérisé en ce qu'**un signal de sortie analogique du potentiomètre d'entrée à réglage numérique (DCPI) est amené au détecteur de crête (PD) et le détecteur de crête (PD) envoie, lors de la détection d'une valeur de crête, qui est supérieure à une valeur limite, un signal de commande par l'intermédiaire d'une entrée d'interruption de l'unité de traitement de signaux numérique (DSP) à l'unité de calcul d'amplification (GCE), et l'unité de calcul d'amplification (GCE) réduit par la suite l'amplification d'entrée par un nouveau réglage du potentiomètre à réglage numérique (DCPI), et
dans lequel le nouveau réglage du potentiomètre d'entrée à réglage numérique (DCPI) est effectué par une routine d'interruption de l'unité de traitement de signaux numérique (DSP) de sorte que la réduction de l'amplification d'entrée n'est pas couplée au traitement cadencé du convertisseur analogique/numérique (ADC) et n'est pas soumise au décalage dans le temps du traitement du convertisseur analogique/numérique (ADC).

8. Microphone sans fil ou émetteur de poche sans fil selon la revendication 7, dans lequel l'unité de traitement de signaux numérique (DSP) présente une unité de compensation (DP, 30) servant à amplifier le signal numérique avec un facteur d'amplification, qui est opposé à l'amplification du potentiomètre d'entrée (DCPI).

9. Microphone sans fil ou émetteur de poche sans fil selon la revendication 8, dans lequel est effectué pour le potentiomètre d'entrée à réglage numérique (DCPI) un étalonnage, les valeurs d'étalonnage sont mémorisées et ces valeurs sont prises en compte lors du calcul de l'amplification opposée par l'unité de compensation (DP, 30).

10. Microphone sans fil ou émetteur de poche sans fil selon l'une quelconque des revendications 7 - 9, dans lequel l'unité de traitement de signaux numérique (DSP) analyse le niveau de signal d'entrée et dans lequel le réglage de l'amplification du potentiomètre d'entrée numérique (DCPI) est effectué de telle manière que le nombre des bits effectifs, lesquels sont utilisés par le convertisseur analogique/numérique (ADC) et le système de traitement de signaux suivant, est augmenté.

11. Microphone sans fil ou émetteur de poche sans fil selon la revendication 10, dans lequel l'opération d'étalonnage est réalisée automatiquement par l'unité de traitement de signaux numérique (DSP).

12. Microphone sans fil ou émetteur de poche sans fil selon la revendication 11, dans lequel l'opération d'étalonnage est répétée de manière automatique à des intervalles fixés dans le temps.

13. Procédé servant à commander un système de transmission audio sans fil numérique, dans lequel le système de transmission audio présente au moins un émetteur sans fil,
qui présente une entrée analogique (AI), un potentiomètre d'entrée à réglage numérique (DCPI) servant à régler une amplification d'entrée, un détecteur de crête (PD), un convertisseur analogique/numérique (ADC) avec un traitement cadencé servant à convertir les signaux analogiques en signaux numériques, et une unité de traitement de signaux numérique (DSP) servant à mettre en œuvre un traitement de signaux numérique, avec l'étape :
- de réglage automatique de l'amplification d'entrée au moyen du potentiomètre d'entrée numérique (DCPI),
dans lequel l'unité de traitement de signaux numérique (DSP) contient une unité de calcul d'amplification (GCE) et est configurée pour régler l'amplification d'entrée,
**caractérisé en ce qu'**un signal de sortie analogique du potentiomètre d'entrée à réglage numérique (DCPI) est associé au détecteur de crête (PD), et le détecteur de crête (PD) envoie, lors de la détection d'une valeur de crête, qui est supérieure à une valeur limite, un signal de commande par l'intermédiaire d'une entrée d'interruption de l'unité de traitement de signaux numérique (DSP) à l'unité de calcul d'amplification (GCE), et l'unité de calcul d'amplification (GCE) réduit par la suite l'amplification d'entrée, et
dans lequel le nouveau réglage du potentiomètre d'entrée à réglage numérique (DCPI) est effectué par une routine d'interruption de l'unité de traitement de signaux numérique (DSP) de sorte que la réduction de l'amplification d'entrée n'est pas couplée au traitement cadencé du convertisseur analogique/numérique (ADC) et n'est pas soumise au décalage dans le temps du traitement du convertisseur analogique/numérique (ADC).

14. Procédé selon la revendication 13, avec l'autre étape
de compensation de l'amplification avec un facteur d'amplification, qui est opposé à l'amplification du potentiomètre d'entrée, dans lequel l'unité de traitement de signaux numérique (DSP) présente une unité de compensation (DP, 30) servant à amplifier le signal numérique avec le facteur d'amplification opposé à l'amplification du potentiomètre d'entrée (DCPI).
